# EUROPÄISCHE PATENTSCHRIFT

(11) **EP 3 189 571 B1**
(45) Veröffentlichungstag und Bekanntmachung des Hinweises auf die Patenterteilung: **15.06.2022**
(21) Anmeldenummer: 15759782.4
(22) Anmeldetag: 04.09.2015
(51) Int. Cl.: H02H 1/00, G01R 31/12

(54) **VERFAHREN ZUR UNTERSCHEIDUNG EINES LICHTBOGENS VON EINEM LEUCHTENDEN GAS ENTHALTEND ZUMINDEST METALLDAMPF**
METHOD FOR DISTINGUISHING AN ARC FROM A LUMINOUS GAS CONTAINING AT LEAST METAL VAPOR
PROCÉDÉ POUR DISTINGUER UN ARC DE LUMIÈRE D'UN GAZ LUMINEUX CONTENANT AU MOINS DE LA VAPEUR DE MÉTAL

(30) Priorität: 04.09.2014 DE 102014112723
(43) Veröffentlichungstag der Anmeldung: 12.07.2017
(73) Patentinhaber: Eaton Intelligent Power Limited, Dublin 4 (IE)
(72) Erfinder: BARTONEK, Michael, 1080 Wien (AT); HAUER, Wolfgang, 4191 Vorderweißenbach (AT)
(74) Vertreter: Eaton IP Group EMEA
(86) Internationale Anmeldenummer: PCT/EP2015/070254
(87) Internationale Veröffentlichungsnummer: WO 2016/034712

(56) Entgegenhaltungen:
- GB-A- 2 419 665
- US-A1- 2008 094 612
- US-B1- 6 229 680

## Beschreibung

### TECHNISCHES GEBIET

Die Erfindung betrifft ein Verfahren und eine Vorrichtung zur Detektion eines Lichtbogens, sowie einen Schaltschrank mit zumindest einem Schaltgerät und mit einer damit verbundenen Vorrichtung der genannten Art.

### STAND DER TECHNIK

Ein solches Verfahren und eine solche Vorrichtung sind grundsätzlich bekannt und werden beispielsweise in elektrischen Anlagen eingesetzt, um etwa Menschen und/oder die Anlage selbst vor den zerstörerischen Auswirkungen eines durch einen Kurzschluss verursachten Lichtbogens zu schützen oder um wenigstens dessen Auswirkungen abzumildern. Beispielsweise können Tiere oder auch herunterfallendes Werkzeug sowie (feuchter) Schmutz die Isolation beziehungsweise die Funkenstrecke zwischen zwei Leitern auf unterschiedlichem Spannungspotential derart herabsetzen, dass ein solcher Lichtbogen entsteht. Durch die teils sehr hohen resultierenden Ströme kann es zu heftigen Explosionen aufgrund der sich in kurzer Zeit aufheizenden Luft kommen.

Häufig werden elektrische Anlagen daher auf das Auftreten eine solchen Lichtbogens überwacht, was in vielen Fällen durch die Messung des über die elektrischen Leiter fließenden Stroms und die Detektion des extrem intensiven Lichts, das von einem Lichtbogen ausgeht, erfolgt. Sind beide Kriterien erfüllt, dann wird ein Alarmsignal ausgegeben, beziehungsweise ein Schaltsignal zum Schließen eines Schalters zwischen den genannten Leitern auf unterschiedlichem Spannungspotential. Dies hat einerseits zur Folge, dass der Lichtbogen rasch gelöscht wird, andererseits auch dass sehr hohe Ströme in den Zuleitungen auftreten, welche einen übergeordneten Überstromschalter auslösen, der letztlich die gefährdete Stelle vom Netz trennt. Selbstverständlich kann das genannte Schaltsignal aber auch direkt zum Öffnen eines Schalters oder mehrerer Schalter in den Zuleitungen zum Lichtbogen dienen.

Zu dieser Thematik sind aus dem Stand der Technik grundsätzlich einige Veröffentlichungen bekannt. Beispielsweise offenbart die US 6,229,680 B1 eine optische Lichtbogenerkennung, bei der das von einer Meßstelle empfangene Licht aufgeteilt und über zwei verschiedene Bandpassfilter geleitet wird. Wenn die Differenz zwischen dem elektrischen Signal, welches aus dem empfangenen Licht resultiert, und dem elektrischen Signal, welches aus einem Hintergrundlicht resultiert, einen Schwellwert überschreitet, dann wird ein Erkennen eines Lichtbogens signalisiert.

Weiterhin offenbart die EP 1 538 722 A2 eine Lichtbogenerkennung, bei der das von einer Meßstelle empfangene Licht mit einer modulierten Referenzlichtquelle gemischt und im Anschluss aufgeteilt und über zwei Bandpassfilter geleitet wird. Wenn ein erstes elektrisches Signal, welches Licht einer ersten Wellenlänge repräsentiert, ein zweites elektrisches Signal übersteigt, das Licht bei einer zweiten Wellenlänge exklusive dem modulierten Referenzlicht repräsentiert, dann wird ein Alarm ausgegeben.

Zudem offenbart die CH 676174 A die Verwendung eines Bandpassfilters, um das von einer Meßstelle empfangene Licht auf einen Wellenlängenbereich eines Lichtbogens zu beschränken.

Die DE 10 2010 016 036 A1 offenbart für die Erkennung eines Lichtbogens darüber hinaus einen Farbsensor mit einem Rotfilter, einem Grünfilter und einem Blaufilter.

Schließlich offenbart die GB 2477970 A eine optische Faser mit einem fluoreszierenden Material, das Licht in einem Wellenlängenbereich, welcher für einen Lichtbogen charakteristisch ist, in Licht einer anderen Wellenlänge transformiert. Dieses transformierte Licht wird anschließend auf einen optischen Sensor geleitet.

Generell ist die zweifelsfreie Erkennung eines gefährlichen, kurzschließenden Lichtbogens nach dem Stand der Technik problematisch. In elektrischen Anlagen können Lichtbögen nämlich auch im normalen Betrieb auftreten, beispielsweise in Form von Schaltlichtbögen beim Trennen eines stromführenden Schaltkontakts. Der Lichtbogen in einem Schaltgerät selbst ist in der Regel zwar nicht direkt sichtbar, allerdings kann leuchtenden Gas aus dem Schaltgerät austreten, das zumindest Metalldampf enthält, der von den abbrennenden Schaltkontakten oder Lichtbogenleitbeziehungsweise Lichtbogenlöschblechen des Schaltgeräts stammt. Daneben kann das Gas auch noch andere Bestandteile enthalten, beispielsweise verdampften Kunststoff vom Gehäuse des Schaltgeräts.

Dieses leuchtende Gas kann irrtümlich als gefährlicher Lichtbogen interpretiert und eine unnötige Abschaltung einer elektrischen, eigentlich im normalen Betrieb befindlichen, Anlage nach sich ziehen. Insbesondere kann ein solches Fehlverhalten nach dem Stand der Technik dann beobachtet werden, wenn ein Kurzschluss einer Phase gegen Masse (ohne Lichtbogen beziehungsweise mit einem Lichtbogen außerhalb des Schaltschranks) einerseits einen sehr hohen messbaren Strom in der Zuleitung, andererseits aber auch die Abschaltung eines zugeordneten Überstromschutzschalters provoziert. Durch die aus dem Überstromschutzschalter austretenden leuchtenden Gase scheinen die beiden eingangs erwähnten Bedingungen (hoher Strom und helles Licht) für einen gefährlichen Lichtbogen nämlich erfüllt zu sein.

### OFFENBARUNG DER ERFINDUNG

Eine Aufgabe ist es daher, ein verbessertes Verfahren und eine verbesserte Vorrichtung zur Detektion eines Lichtbogens anzugeben. Insbesondere soll ein gefährlicher Lichtbogen sicher erkannt und eine unnötige Abschaltung einer elektrischen Anlage vermieden werden.

Diese Aufgabe wird mit einem Verfahren zur Unterscheidung eines Lichtbogens von einem leuchtenden Gas zumindest enthaltend Metalldampf 2. nach Anspruch 1 gelöst. Das Verfahren weist folgende Schritte auf:
- Erfassen von Licht in einem Überwachungsbereich,
- Messen einer ersten Intensität I_{λ1} des erfassten Lichts bei einer ersten Wellenlänge λ1,
- Messen einer zweiten Intensität I_{λ2} des erfassten Lichts bei einer zweiten, größeren Wellenlänge λ2,
- Ermitteln des Verhältnisses I_{λ1} / I_{λ2} zwischen der ersten Intensität I_{λ1} und der zweiten Intensität I_{λ2} und
- Zuordnen des erfassten Lichts einem leuchtenden Gas zumindest enthaltend Metalldampf, wenn das genannte Verhältnis I_{λ1} / I_{λ2} kleiner ist als ein vorgebbarer zweiter Schwellwert.

Die Aufgabe der Erfindung wird auch mit einer Vorrichtung zur Unterscheidung eines Lichtbogens von einem leuchtenden Gas zumindest enthaltend Metalldampf 2. nach Anspruch 6 gelöst.

Die Vorrrichtung umfasst
- zumindest ein lichtempfindliches Element zum Erfassen von Licht in einem Überwachungsbereich,
- eine Messeinrichtung zum Messen einer ersten Intensität I_{λ1} des erfassten Lichts bei einer ersten Wellenlänge λ1 und zum Messen einer zweiten Intensität I_{λ2} des erfassten Lichts bei einer zweiten, größeren Wellenlänge λ2 und
- eine Auswerteeinheit zum Ermitteln des Verhältnisses I_{λ1} / I_{λ2} zwischen der ersten Intensität I_{λ1} und der zweiten Intensität I_{λ2} und zum Zuordnen des erfassten Lichts zu einem leuchtenden Gas zumindest enthaltend Metalldampf, wenn das genannte Verhältnis I_{λ1} / I_{λ2} kleiner ist als ein vorgebbarer zweiter Schwellwert.

Schließlich wird die Aufgabe der Erfindung durch eine Verwendung eines Verfahrens der oben genannten Art beziehungsweise einer Vorrichtung der oben genannten Art zur Überwachung eines in einem Schaltschrank angeordneten Überwachungsbereichs gelöst.

Durch die vorgeschlagenen Maßnahmen kann ein gefährlicher Lichtbogen mit hoher Sicherheit von (potentiell ungefährlichen) aus einem Schaltgerät austretenden leuchtenden Gasen unterschieden werden. Dabei macht man sich den Umstand zu Nutze, dass das Lichtspektrum des leuchtenden Gases ein anderes ist als das des Lichtbogens. Die Temperatur des leuchtenden (brennenden) Gases liegt in etwa bei 2500°K bis 4500°K, wohingegen die Temperatur des Lichtbogens etwa zwischen 10000°K und 20000°K liegt. Demzufolge hat das von einem Lichtbogen emittierte Licht einen höheren Anteil an kurzwelliger Strahlung.

Vorteilhaft kann zur Lösung der gestellten Aufgabe auf komplizierte Spektralanalysen verzichtet werden. Stattdessen werden zwei Werte für die Intensität des Lichts in zwei dezidierten Wellenlängenbereichen ermittelt und in der oben genannten Weise durch einfache mathematische Operationen und Vergleiche zur Unterscheidung eines Lichtbogens von einem leuchtenden Gas zumindest enthaltend Metalldampf herangezogen. Aufgrund dieser Tatsache ist das vorgestellte Verfahren auch wenig störanfällig und kann mit geringem technischen Aufwand in die Praxis umgesetzt werden.

An dieser Stelle wird angemerkt, dass das leuchtende Gas neben Metalldampf insbesondere auch gasförmige Zersetzungsprodukte von Kunststoffen wie z.B. Wasserstoff, Kohlenstoff, Kohlenwasserstoffe und dergleichen enthalten kann. Trotz dieser Varianz in der Zusammensetzung des leuchtenden Gases ermöglicht das vorgestellte Verfahren beziehungsweise die vorgestellte Vorrichtung die sichere Detektion des leuchtenden Gases, beziehungsweise die sichere Unterscheidung eines Lichtbogens von einem leuchtenden Gas.

Es kann vorgesehen sein, dass das erfasste Licht einem Lichtbogen zugeordnet wird, wenn das genannte Verhältnis I_{λ1} / I_{λ2} in einem ersten Bereich liegt und zu einem leuchtenden Gas zumindest enthaltend Metalldampf, wenn das genannte Verhältnis I_{λ1} / I_{λ2} in einem zweiten Bereich liegt. Das heißt, dass zusätzlich zum ersten unteren Schwellwert ein zugeordneter oberer Schwellwert und zusätzlich zum zweiten oberen Schwellwert ein zugeordneter unterer Schwellwert vorgesehen wird.

Weitere vorteilhafte Ausgestaltungen und Weiterbildungen der Erfindung ergeben sich aus den Unteransprüchen sowie aus der Beschreibung in Zusammenschau mit den Figuren.

Erfindungsgemäß wird die erste Wellenlänge λ1 in einem Bereich zwischen 300 nm und 400 nm und die zweite Wellenlänge λ2 in einem Bereich zwischen 650 nm und 750 nm gewählt.

Besonders vorteilhaft ist dabei, wenn für die erste Wellenlänge λ1 = 350 nm und/oder für die zweite Wellenlänge λ2 = 700 nm gewählt wird. Diese Wellenlängen beziehungsweise Wellenlängenbereiche haben sich als besonders geeignet für die Unterscheidung eines Lichtbogens von einem leuchtenden Gas herausgestellt.

Besonders vorteilhaft wird der erste Schwellwert und/oder der zweite Schwellwert in einem Bereich von 0,0125 bis 5 gewählt. Bevorzugt ist der zweite Schwellwert dabei kleiner gleich dem ersten Schwellwert, prinzipiell kann der zweite Schwellwert aber auch größer sein als der erste Schwellwert. In diesem Bereich wird eine gute Unterscheidung eines Lichtbogens von einem leuchtenden Gas ermöglicht.

Vorteilhaft ist es weiterhin, wenn für den ersten Schwellwert und/oder den zweiten Schwellwert der Wert 2,5 gewählt wird. Weitere besonders bevorzugte Werte für den ersten Schwellwert sind 3,5 und 4,5, für den zweiten Schwellwert 1,5 und 0,5. Auf diese Weise gelingt die Unterscheidung eines Lichtbogens von einem leuchtenden Gas besonders gut.

Günstig ist es auch, wenn die Vorrichtung zur Unterscheidung eines Lichtbogens von einem leuchtenden Gas einen Ausgang aufweist, welcher zur Ausgabe eines ersten Alarms beziehungsweise eines ersten Schaltsignals im Falle eines im Überwachungsbereich festgestellten Lichtbogens ausgebildet ist. Dementsprechend ist es günstig, wenn ein erster Alarm beziehungsweise ein erstes Schaltsignal ausgegeben wird, wenn im Überwachungsbereich ein Lichtbogen festgestellt wird. Dadurch kann eine übergeordnete Steuerung oder Überwachungspersonal über die Störung in der elektrischen Anlage informiert werden. Alternativ oder zusätzlich kann das erste Schaltsignal direkt auf ein Schaltgerät geführt werden, das die elektrische Anlage im Fehlerfall automatisch von einem versorgenden Stromnetz trennt. Denkbar wäre auch, dass das erste Schaltsignal auf ein Schaltgerät geführt wird, das den Lichtbogen kurzschließt und ihn damit löscht. Der resultierende hohe Kurzschlußstrom führt in Folge zur Abschaltung eines Überstromschutzschalters in der betreffenden Zuleitung. Das erste Schaltsignal kann also sowohl das Schließen eines Schaltkontakts als auch das Öffnen eines Schaltkontakts bewirken.

Besonders vorteilhaft ist es, wenn der erste Alarm beziehungsweise das erste Schaltsignal ausgegeben wird, wenn im Überwachungsbereich ein Lichtbogen und zusätzlich ein über einem dritten Schwellwert liegender Strom in einer zum Überwachungsbereich führenden Zuleitung festgestellt wird. Durch die Aufnahme eines weiteren Kriteriums kann eine gefährliche Situation im Überwachungsbereich besonders gut erkannt werden.

Günstig ist es zudem, wenn die Vorrichtung zur Unterscheidung eines Lichtbogens von einem leuchtenden Gas einen Ausgang aufweist, welcher zur Ausgabe eines zweiten Alarms/Schaltsignals im Falle eines im Überwachungsbereich festgestellten leuchtenden Gases zumindest enthaltend Metalldampf ausgebildet ist und/oder eines dritten Alarms/Schaltsignals im Falle, dass das im Überwachungsbereich erfasste Licht weder einem Lichtbogen noch einem leuchtenden Gas zumindest enthaltend Metalldampf zuordenbar ist. Dementsprechend ist es günstig, wenn ein zweiter Alarm beziehungsweise ein zweites Schaltsignal ausgegeben wird, wenn im Überwachungsbereich ein leuchtendes Gas zumindest enthaltend Metalldampf festgestellt wird und/oder ein dritter Alarm beziehungsweise ein drittes Schaltsignal, wenn das im Überwachungsbereich erfasste Licht weder einem Lichtbogen noch einem leuchtenden Gas zumindest enthaltend Metalldampf zuordenbar ist. Konkret wird der dritte Alarm/das dritte Schaltsignal ausgegeben, wenn das Verhältnis I_{λ1} / I_{λ2} zwischen dem ersten und dem zweiten Schwellwert liegt. Sind für die Zuordnung des erfassten Lichts zu einem Lichtbogen oder einem leuchtenden Gas zumindest enthaltend Metalldampf Wertebereiche vorgesehen, so wird der dritte Alarm/das dritte Schaltsignal ausgegeben, wenn das Verhältnis I_{λ1} / I_{λ2} außerhalb der für den Lichtbogen beziehungsweise das leuchtende Gas vorgesehenen Wertebereiche liegt.

Durch die vorgeschlagenen Maßnahmen kann dem Überwachungspersonal beziehungsweise einer übergeordneten Steuerung zusätzliche Information zur Verfügung gestellt werden, die nicht unbedingt eine gefährliche Situation im Schaltschrank kennzeichnet. Konkret wird nicht nur ein Lichtbogen im Schaltschrank signalisiert, sondern auch ein aus einem Schaltgerät austretendes leuchtendes Gas sowie eine andere Lichtquelle, wie zum Beispiel in den Schaltschrank dringendes Tageslicht beim Öffnen desselben oder auch ein Fotoblitz. Das zweite und/oder dritte Schaltsignal kann wiederum auf ein Schaltgerät geführt werden und einen Stromkreis trennen oder schließen.

Vorteilhaft weist die Vorrichtung zur Unterscheidung eines Lichtbogens von einem leuchtenden Gas zwei lichtempfindliche Elemente und den lichtempfindlichen Elementen vorgelagerte optische Filter auf, wobei der oder die dem ersten lichtempfindliche Element vorgelagerten Filter vorwiegend Licht der ersten Wellenlänge und der oder die dem zweiten lichtempfindlichen Element vorgelagerten Filter vorwiegend Licht der zweiten Wellenlänge passieren lassen. Insbesondere können der erste und/oder der zweite optische Filter als Bandpassfilter ausgebildet sein. Auf diese Weise können zwei identisch aufgebaute lichtempfindliche Elemente zur Erfassung des Lichts aus dem Überwachungsbereich verwendet werden. Denkbar ist prinzipiell jedoch der Einsatz eines Hochpassfilters und eines Tiefpassfilters.

Besonders vorteilhaft ist es bei Verwendung von Bandpassfiltern, wenn der erste optische Filter Licht in einem Wellenlängenbereich zwischen 300 nm und 400 nm und/oder der zweite optische Filter Licht in einem Wellenlängenbereich zwischen 650 nm und 750 nm passieren lässt, beziehungsweise wenn eine maximale Durchlässigkeit des ersten optischen Filters in diesem Wellenlängenbereich und insbesondere bei 350 nm und eine maximale Durchlässigkeit des zweiten optischen Filters in dem oben genannten Wellenlängenbereich und insbesondere bei 700 nm liegt. Wie bereits erwähnt, haben sich diese Wellenlängen beziehungsweise Wellenlängenbereiche als besonders geeignet für die Unterscheidung eines Lichtbogens von einem leuchtenden Gas herausgestellt.

Besonders vorteilhaft ist es auch, wenn der Überwachungsbereich innerhalb eines Schaltschranks angeordnet ist. Die Vorteile der Erfindung treten hier besonders hervor, da sich innerhalb eines Schaltschranks häufig die Problematik ergibt, dass ein Lichtbogen sicher von einem leuchtenden Gas unterschieden werden muss.

An dieser Stelle wird angemerkt, dass sich die zum vorgestellten Verfahren offenbarten Varianten und die daraus resultierenden Vorteile gleichermaßen auf die Vorrichtung zur Unterscheidung eines Lichtbogens von einem leuchtenden Gas, den vorgestellten Schaltschrank sowie die präsentierte Verwendung eines solchen Verfahrens respektive einer solchen Vorrichtung beziehen und umgekehrt.

### KURZE BESCHREIBUNG DER FIGUREN

Die vorliegende Erfindung wird nachfolgend anhand der in den schematischen Figuren der Zeichnung angegebenen Ausführungsbeispiele näher erläutert. Es zeigen dabei:
- Fig. 1: zeigt ein beispielhaftes Diagramm für die absolute spektrale Bestrahlungsstärke [µW·cm⁻²·nm⁻¹] in Abhängigkeit der Wellenlänge λ für einen Lichtbogen und ein leuchtendes Gas;
- Fig. 2: eine beispielhafte Vorrichtung zur Unterscheidung eines Lichtbogens von einem leuchtenden Gas;
- Fig. 3: einen beispielhaften Schaltschrank mit einer Vorrichtung zur Unterscheidung eines Lichtbogens von einem leuchtenden Gas und
- Fig. 4: ähnlich wie Fig. 3, jedoch mit einer Einrichtung zur Löschung eines Lichtbogens.

### DETAILIERTE BESCHREIBUNG DER ERFINDUNG

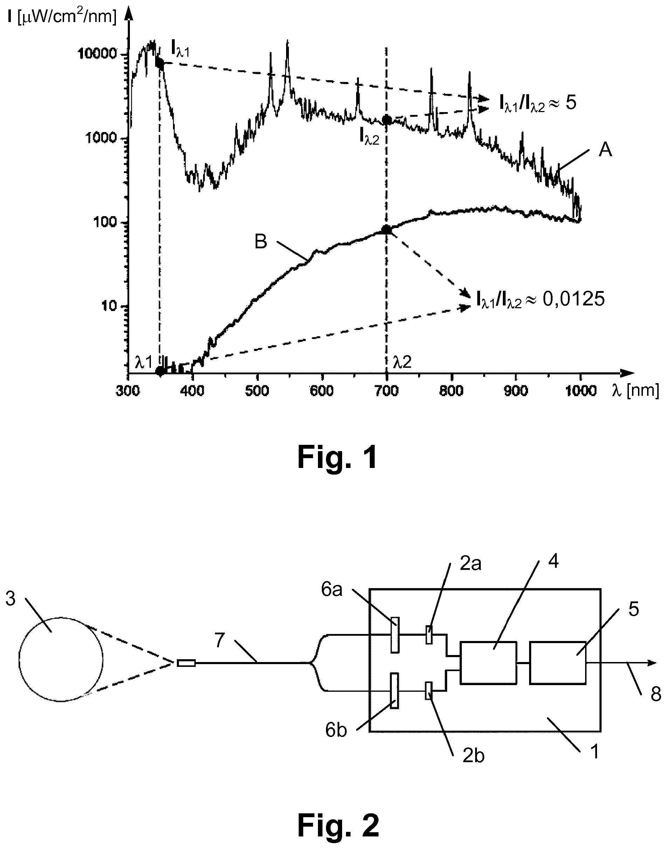

Fig. 1 zeigt ein Diagramm für die absolute Bestrahlungsstärke I in Abhängigkeit der Wellenlänge λ für einen Lichtbogen (Graph A) und ein leuchtendes Gas zumindest enthaltend Metalldampf (Graph B).

Bei einem Verfahren zur Unterscheidung eines Lichtbogens von einem leuchtenden Gas zumindest enthaltend Metalldampf wird
- Licht in einem Überwachungsbereich erfasst,
- eine erste Intensität I_{λ1} des erfassten Lichts bei einer ersten Wellenlänge λ1 gemessen,
- eine zweite Intensität I_{λ2} des erfassten Lichts bei einer zweiten, größeren Wellenlänge λ2 gemessen,
- das Verhältnis I_{λ1} / I_{λ2} zwischen der ersten Intensität I_{λ1} und der zweiten Intensität I_{λ2} ermittelt und
- das erfasste Licht zu einem Lichtbogen zugeordnet, wenn das genannte Verhältnis I_{λ1} / I_{λ2} größer ist als ein vorgebbarer erster Schwellwert und einem leuchtenden Gas zumindest enthaltend Metalldampf, wenn das genannte Verhältnis I_{λ1} / I_{λ2} kleiner ist als ein vorgebbarer zweiter Schwellwert.

Erfindungsgemäß wird die erste Wellenlänge λ1 in einem Bereich zwischen 300 nm und 400 nm 2. und die zweite Wellenlänge λ2 in einem Bereich zwischen 650 nm und 750 nm gewählt. In dem in Fig. 1 konkret dargestellten Beispiel ist für die erste Wellenlänge λ1 = 350 nm und/oder für die zweite Wellenlänge λ2 = 700 nm vorgesehen. In dem in Fig. 1 dargestellten Beispiel ergibt sich für das Verhältnis I_{λ1} / I_{λ2} im Falle des Lichtbogens (Graph A) der Wert 5, im Falle des leuchtenden Gases (Graph B) der Wert 0,0125. Wird für den ersten und zweiten Schwellwert der Wert 2,5 gewählt, so ergibt sich eine eindeutige Zuordnung des gemessenen Verhältnisses I_{λ1} / I_{λ2} zu einem Lichtbogen beziehungsweise zu einem leuchtenden Gas zumindest enthaltend Metalldampf. Weitere besonders bevorzugte Werte für den ersten Schwellwert sind 3,5 und 4,5, für den zweiten Schwellwert 1,5 und 0,5. Generell sollten der erste und der zweite Schwellwert in einem Bereich von 0,0125 und 5 liegen, wobei der zweite Schwellwert bevorzugt kleiner gleich dem ersten Schwellwert ist.

Somit umfasst das vorgestellte Verfahren in dem gezeigten Beispiel die konkreten Schritte:
- Erfassen von Licht in einem Überwachungsbereich,
- Messen einer ersten Intensität I_{λ1} des erfassten Lichts bei einer Wellenlänge λ1 = 350 nm,
- Messen einer zweiten Intensität I_{λ2} des erfassten Lichts bei einer zweiten, größeren Wellenlänge λ2 = 700nm,
- Ermitteln des Verhältnisses I_{λ1} / I_{λ2} zwischen der ersten Intensität I_{λ1} und der zweiten Intensität I_{λ2} und
- Zuordnen des erfassten Lichts zu einem Lichtbogen, wenn das genannte Verhältnis I_{λ1} / I_{λ2} größer ist als 2,5 und zu einem leuchtenden Gas zumindest enthaltend Metalldampf, wenn das genannte Verhältnis I_{λ1} / I_{λ2} kleiner ist als 2,5. Vorteilhaft reichen für die Zuordnung des Lichts zu einem Lichtbogen oder einem leuchtenden Gas eine Messung zweier Werte für die Intensität I_{λ1}, I_{λ2} des Lichts in zwei dezidierten Wellenlängenbereichen λ1, λ2 sowie einfache mathematische Operationen und Vergleiche aus. Auf komplizierte Spektralanalysen kann dagegen verzichtet werden. Das vorgestellte Verfahren ist daher wenig störanfällig und kann mit geringem technischen Aufwand in die Praxis umgesetzt werden, wie dies in der Fig. 2 gezeigt ist.

Fig. 2 zeigt eine beispielhafte Vorrichtung 1 zur Unterscheidung eines Lichtbogens von einem leuchtenden Gas zumindest enthaltend Metalldampf. Die Vorrichtung 1 umfasst
- zwei lichtempfindliche Elemente 2a, 2b zum Erfassen von Licht in einem Überwachungsbereich 3,
- eine Messeinrichtung 4 zum Messen einer ersten Intensität I_{λ1} des erfassten Lichts bei einer ersten Wellenlänge λ1 und zum Messen einer zweiten Intensität I_{λ2} des erfassten Lichts bei einer zweiten, größeren Wellenlänge λ2, und
- eine Auswerteinheit 5 zum Ermitteln des Verhältnisses I_{λ1} / I_{λ2} zwischen der ersten Intensität I_{λ1} und der zweiten Intensität I_{λ2} und zum Zuordnen des erfassten Lichts zu einem Lichtbogen, wenn das genannte Verhältnis I_{λ1} / I_{λ2} größer ist als ein vorgebbarer erster Schwellwert und zu einem leuchtenden Gas zumindest enthaltend Metalldampf, wenn das genannte Verhältnis I_{λ1} / I_{λ2} kleiner ist als ein vorgebbarer zweiter Schwellwert.

Den beiden lichtempfindlichen Elementen 2a, 2b sind in diesem Beispiel zwei optische Filter 6a, 6b vorgelagert, wobei der dem ersten lichtempfindlichen Element 2a vorgelagerte Filter 6a vorwiegend Licht der ersten Wellenlänge λ1 und der dem zweiten lichtempfindlichen Element 2b vorgelagerte Filter 6b vorwiegend Licht der zweiten Wellenlänge λ2 passieren lässt. Konkret sind die beiden optischen Filter 6a, 6b vorteilhaft als Bandpassfilter ausgebildet. Unter Bezugnahme auf das in Fig. 1 gezeigte Beispiel kann insbesondere vorgesehen sein, dass der erste Filter 6a vorwiegend Licht mit einer Wellenlänge von λ1 = 350 nm und der zweite Filter 6b vorwiegend Licht mit einer Wellenlänge von λ2 = 700 nm passieren lässt.

Weiterhin ist die Vorrichtung 1 mit einem optionalen Lichtleiter 7 verbunden, welcher das Licht vom Überwachungsbereich 3 zu den optischen Filtern 6a, 6b respektive zu den lichtempfindlichen Elementen 2a, 2b leitet. Schließlich weist die Vorrichtung 1 noch einen optionalen Alarmausgang beziehungsweise Schaltausgang 8 auf.

Die Funktion der in der Fig. 2 dargestellten Anordnung ist wie folgt:
Licht wird vom Überwachungsbereich 3 über den Lichtleiter 7 und die optischen Filter 6a, 6b an die lichtempfindlichen Elemente 2a, 2b geleitet, welche das Licht in ein elektrisches Signal umwandeln. Dieses elektrische Signal wird von der Messeinrichtung 4 ausgewertet und in Intensitätswerte I_{λ1}, I_{λ2} des erfassten Lichts umgewandelt. Die Auswerteinheit 5 bestimmt das Verhältnis I_{λ1} / I_{λ2} zwischen der ersten Intensität I_{λ1} und der zweiten Intensität I_{λ2} und ordnet das erfasste Licht einem Lichtbogen zu, wenn das genannte Verhältnis I_{λ1} / I_{λ2} größer ist als ein vorgebbarer erster Schwellwert und zu einem leuchtenden Gas zumindest enthaltend Metalldampf, wenn das genannte Verhältnis I_{λ1} / I_{λ2} kleiner ist als ein vorgebbarer zweiter Schwellwert. Unter Bezugnahme auf die Fig. 1 wird für den ersten Schwellwert und den zweiten Schwellwert insbesondere der Wert 2,5 gewählt. Denkbar sind aber natürlich auch alle anderen im Zusammenhang mit der Fig. 1 genannten Schwellwerte. Vorzugsweise wird über den Alarmausgang beziehungsweise Schaltausgang 8 ein erster Alarm beziehungsweise ein erstes Schaltsignal ausgegeben, wenn im Überwachungsbereich 3 ein Lichtbogen festgestellt wird. Selbstverständlich, kann die Detektion eines Lichtbogens oder eines leuchtenden Gases auch auf andere Weise weitergeleitet werden. Insbesondere ist es auch möglich, dass zusätzlich zum Lichtbogen oder alternativ dazu die Detektion eines leuchtenden Gases respektive das Auftreten von Licht, das weder einem Lichtbogen noch einem leuchtenden Gas zuordenbar ist, gemeldet wird.

Generell kann die Messeinrichtung 4 als Analog-Digital-Wandler ausgebildet sein, welcher das elektrische Signal der lichtempfindlichen Elemente 2a, 2b in einen Digitalwert umwandelt, und die Auswerteeinheit 5 als Mikroprozessor, in welcher ein Softwarealgorithmus zur Bestimmung des Verhältnisses I_{λ1} / I_{λ2} und zur Zuordnung des empfangenen Lichts zu einem Lichtbogen beziehungsweise zu einem leuchtenden Gas ausgeführt wird.

Denkbar wäre aber auch dass die Bestimmung des Verhältnisses I_{λ1} / I_{λ2} und zur Zuordnung des empfangenen Lichts zu einem Lichtbogen beziehungsweise zu einem leuchtenden Gas mit Hilfe von Analog-Bausteinen durchgeführt wird. Die Messeinrichtung 4 dient in diesem Fall vorwiegend der Signalverstärkung, kann prinzipiell aber auch entfallen.

Denkbar wäre weiterhin, dass ein lichtempfindliches Element 2a, 2b und eine Messeinrichtung 4 eine bauliche Einheit bilden. Beispielsweise kann dieses Bauelement ein (verstärktes) Analogsignal oder aber auch direkt einen Digitalwert ausgeben. In einer weiteren Ausführungsvariante kann ein lichtempfindliches Element 2a, 2b und ein optischer Filter 6a, 6b eine bauliche Einheit bilden. Beispielsweise kann das Gehäuse des lichtempfindlichen Elements 2a, 2b dementsprechend eingefärbt sein. Weiterhin ist auch eine Kombination eines lichtempfindlichen Elements 2a, 2b, einer Messeinrichtung 4 und eines optischen Filters 6a, 6b in einer baulichen Einheit vorstellbar.

Schließlich ist es auch die Verwendung lediglich eines lichtempfindlichen Elements 2a denkbar, vor das die optischen Filter 6a, 6b zeitlich hintereinander bewegt werden. Beispielsweise können sich die Filter 6a, 6b auf einer motorisch angetriebenen und sich drehenden Scheibe befinden.

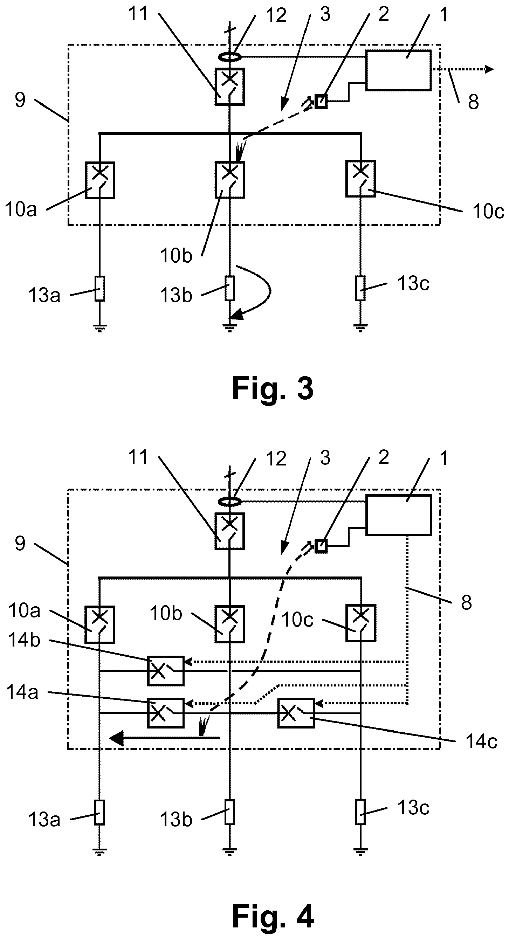

Fig. 3 zeigt nun einen rein symbolisch dargestellten beispielhaften Schaltschrank 9 mit drei je einer Phase eines Dreiphasensystems zugeordneten Überstromschutzschaltern 10a..10c, einem übergeordneten Überstromschutzschalter 11, sowie einer Vorrichtung 1 zur Unterscheidung eines Lichtbogens von einem leuchtenden Gas zumindest enthaltend Metalldampf, welche mit einem lichtempfindlichen Element 2 sowie einer Strommeßschleife 12 verbunden ist. Zudem weist die genannte Vorrichtung 1 einen Alarmausgang beziehungsweise Schaltausgang 8 auf. An den Schaltschrank 9 sind schließlich auch drei Verbraucher 13a..13c angeschlossen.

Die Vorrichtung 1 weist in diesem Beispiel einen gegenüber dem in Fig. 2 dargestellten Beispiel erweiterten Funktionsumfang auf, dahingehend, dass zusätzlich zur optischen Überwachung eines Überwachungsbereichs 3 auch das Signal einer Strommeßschleife 12 ausgewertet wird. In diesem Beispiel wird dann ein erstes Alarmsignal und/oder erstes Schaltsignal über den Ausgang 8 ausgegeben, wenn ein Lichtbogen detektiert wird, was mit dem bereits oben beschriebenen Verfahren erfolgt, UND wenn der von der Strommeßschleife 12 gemessene Strom einen Schwellwert überschreitet.

In dem in Fig. 3 dargestellten Beispiel verursacht ein Kurschluss am Verbraucher 13b einen erhöhten Stromfluss über den Überstromschutzschalter 10b, den übergeordneten Überstromschutzschalter 11 sowie über die Strommeßschleife 12. Durch den Kurzschlußstrom löst der Überstromschutzschalter 10b aus, wodurch in an sich bekannter Weise ein Lichtbogen über den sich öffnenden Kontakten entsteht.

Der Lichtbogen im Überstromschutzschalter 10b selbst ist für das lichtempfindliche Element 2 in der Regel zwar nicht direkt sichtbar, allerdings kann leuchtenden Gas aus dem Überstromschutzschalter 10b austreten, das zumindest Metalldampf enthält, der von den abbrennenden Schaltkontakten oder Lichtbogenleitbeziehungsweise Lichtbogenlöschblechen des Überstromschutzschalter 10b stammt. Daneben kann das Gas auch noch andere Bestandteile enthalten, beispielsweise verdampften Kunststoff vom Gehäuse des Überstromschutzschalters 10b.

Lichtbogen-Detektionsvorrichtungen nach dem Stand der Technik geben in dieser Situation fälschlicherweise ein Alarmsignal beziehungsweise Schaltsignal aus, da einerseits helles Licht im Schaltschrank 9 detektierbar ist, andererseits auch ein übermäßig hoher Strom über die Strommeßschleife 12 festgestellt wird.

Die erfindungsgemäße Vorrichtung 1 kann jedoch einen im Schaltschrank 9 sichtbar brennenden Lichtbogen sicher von dem leuchtenden Gas unterscheiden und gibt in einer solchen Situation kein fälschliches Alarmsignal beziehungsweise Schaltsignal aus. Dieses wird nur ausgegeben, wenn ein Lichtbogen im Schaltschrank 9 sichtbar brennt, beispielsweise weil in den Schaltschrank kriechende Tiere oder auch herunterfallendes Werkzeug die Isolation beziehungsweise Funkenstrecke zwischen zwei Leitern auf unterschiedlichem Spannungspotential so stark herabsetzen, das ein solcher Lichtbogen entsteht.

Fig. 4 zeigt eine Anordnung, die der in Fig. 3 dargestellten Anordnung sehr ähnlich ist. Zusätzlich sind aber Schaltgeräte 14a..14c vorhanden, welche die einzelnen Phasen gegeneinander kurzschließen können. Das erste Schaltsignal 8 kann in diesem Fall beispielsweise an die Eingänge der Schaltgeräte 14a..14c geführt sein. Tritt ein Fehlerfall auf, so werden die Schaltgeräte 14a..14c geschlossen und löschen damit den zwischen den Phasen brennenden Lichtbogen. Der durch den Kurschluss hervorgerufene Überstrom löst in Folge die Überstromschutzschalter 10a..10c beziehungsweise den Überstromschutzschalter 11 aus, wodurch die Anlage letztlich vom Stromnetz getrennt wird. Selbstverständlich kann das erste Schaltsignal 8 auch aus dem Schaltschrank 9 heraus geführt sein und beispielsweise eine Alarmierung bewirken. Denkbar ist auch, dass die Schaltgeräte 14a..14c mit der Masse verbunden sind, wodurch die Phasen mit Hilfe der Schaltgeräte 14a..14c demzufolge gegen Masse (und gegeneinander) kurzgeschlossen werden können.

An dieser Stelle wird angemerkt, dass nicht nur das Auftreten eines leuchtenden Gases zumindest enthaltend Metalldampf (zweiter Alarm/zweites Schaltsignal), sondern auch das Auftreten eines Lichtbogens (erster Alarm/erstes Schaltsignal) sowie das Auftreten von Licht, das weder einem Lichtbogen noch einem leuchtenden Gas zumindest enthaltend Metalldampf zuordenbar ist, (dritter Alarm/drittes Schaltsignal) gemeldet werden kann. Die zum ersten Alarm/ersten Schaltsignal offenbarte Lehre ist dabei sinngemäß auch auf den zweiten Alarm/das zweite Schaltsignal sowie auf den dritten Alarm/das dritte Schaltsignal anwendbar. Beispielsweise kann das zweite und/oder dritte Schaltsignal auf ein Schaltgerät geführt werden und einen Stromkreis trennen oder schließen. Insbesondere kann dem Überwachungspersonal oder einer übergeordneten Steuerung auf diese Weise zusätzliche Information zur Verfügung gestellt werden, die nicht unbedingt eine gefährliche Situation im Schaltschrank 9 kennzeichnet. Im Speziellen kann zum Beispiel in den Schaltschrank 9 dringendes Tageslicht beim Öffnen desselben oder auch ein Fotoblitz erkannt und gemeldet werden.

Abschließend wird angemerkt, dass die Vorrichtung 1 und der Schaltschrank 9 respektive deren oder dessen Bauteile nicht notwendigerweise maßstäblich dargestellt sind und daher auch andere Proportionen aufweisen können. Weiterhin können eine Vorrichtung 1 zur Unterscheidung eines Lichtbogens von einem leuchtenden Gas respektive der Schaltschrank 9 auch mehr oder weniger Bauteile als dargestellt umfassen. Lageangaben (z.B. "oben", "unten", "links", "rechts", etc.) sind auf die jeweils beschriebene Figur bezogen und sind bei einer Lageänderung sinngemäß an die neue Lage anzupassen. Schließlich wird angemerkt, dass sich die obigen Ausgestaltungen und Weiterbildungen der Erfindung auf beliebige Art und Weise kombinieren lassen.

## Patentansprüche

1. Verfahren zur Unterscheidung eines Lichtbogens von einem leuchtenden Gas zumindest enthaltend Metalldampf, umfassend die Schritte
- Erfassen von Licht in einem Überwachungsbereich (3),
- Messen einer ersten Intensität des erfassten Lichts bei einer ersten Wellenlänge λ1,
- Messen einer zweiten Intensität des erfassten Lichts bei einer zweiten, größeren Wellenlänge λ2,
wobei
- das Verhältnis I_{λ1} / I_{λ2} zwischen der ersten Intensität I_{λ1} und der zweiten Intensität I_{λ2} ermittelt wird und
- das erfasste Licht zu einem leuchtenden Gas zumindest enthaltend Metalldampf zugeordnet wird, wenn das genannte Verhältnis I_{λ1} / I_{λ2} kleiner ist als ein vorgebbarer zweiter Schwellwert, wobei
- die erste Wellenlänge λ1 in einem Bereich zwischen 300 nm und 400 nm und die zweite Wellenlänge λ2 in einem Bereich zwischen 650 nm und 750 nm gewählt wird.

2. Verfahren nach Anspruch 1, **dadurch gekennzeichnet, dass** der zweite Schwellwert in einem Bereich von 0,0125 bis 5 gewählt wird.

3. Verfahren nach Anspruch 1 oder 2, **dadurch gekennzeichnet, dass** für den zweiten Schwellwert der Wert 2,5 gewählt wird.

4. Verfahren nach einem der Ansprüche 1 bis 3, **dadurch gekennzeichnet, dass** ein zweiter Alarm beziehungsweise ein zweites Schaltsignal ausgegeben wird, wenn im Überwachungsbereich (3) ein leuchtendes Gas zumindest enthaltend Metalldampf festgestellt wird und/oder ein dritter Alarm beziehungsweise ein drittes Schaltsignal, wenn das im Überwachungsbereich (3) erfasste Licht einem leuchtenden Gas zumindest enthaltend Metalldampf nicht zuordenbar ist.

5. Verfahren nach einem der Ansprüche 1 bis 4, **dadurch gekennzeichnet, dass** der Überwachungsbereich (3) innerhalb eines Schaltschranks angeordnet ist.

6. Vorrichtung (1) zur Unterscheidung eines Lichtbogens von einem leuchtenden Gas zumindest enthaltend Metalldampf, umfassend
- zumindest ein lichtempfindliches Element (2a, 2b) zum Erfassen von Licht in einem Überwachungsbereich (3),
- eine Messeinrichtung (4) zum Messen einer ersten Intensität I_{λ1} des erfassten Lichts bei einer ersten Wellenlänge λ1 und zum Messen einer zweiten Intensität I_{λ2} des erfassten Lichts bei einer zweiten, größeren Wellenlänge λ2,
und
- eine Auswerteeinheit (5) zum Ermitteln des Verhältnisses I_{λ1} / I_{λ2} zwischen der ersten Intensität I_{λ1} und der zweiten Intensität I_{λ2} und zum Zuordnen des erfassten Lichts zu einem leuchtenden Gas zumindest enthaltend Metalldampf, wenn das genannte Verhältnis I_{λ1} / I_{λ2} kleiner ist als ein vorgebbarer zweiter Schwellwert, wobei die erste Wellenlänge λ1 in einem Bereich zwischen 300 nm und 400 nm und die zweite Wellenlänge λ2 in einem Bereich zwischen 650 nm und 750 nm liegt.

7. Vorrichtung (1) nach Anspruch 6, **gekennzeichnet durch** zwei lichtempfindliche Elemente (2a, 2b) und den lichtempfindlichen Elementen (2a, 2b) vorgelagerte optische Filter (6a, 6b), wobei der oder die dem ersten lichtempfindlichen Element (2a) vorgelagerten Filter (6a) vorwiegend Licht der ersten Wellenlänge λ1 und der oder die dem zweiten lichtempfindliche Element (2b) vorgelagerten Filter (6b) vorwiegend Licht der zweiten Wellenlänge λ2 passieren lassen.

8. Vorrichtung (1) nach Anspruch 7, **dadurch gekennzeichnet, dass** der erste und/oder zweite optische Filter (6a, 6b) als Bandpassfilter ausgebildet ist/sind.

9. Vorrichtung (1) nach Anspruch 8, **dadurch gekennzeichnet, dass** eine maximale Durchlässigkeit des ersten optischen Filters (6a) in einem Wellenlängenbereich zwischen 300 nm und 400 nm und eine maximale Durchlässigkeit des zweiten optischen Filters (6b) in einem Wellenlängenbereich zwischen 650 nm und 750 nm liegt.

10. Vorrichtung (1) nach einem der Ansprüche 6 bis 9, **gekennzeichnet durch** einen Ausgang (8), welcher zur Ausgabe eines zweiten Alarms/Schaltsignals im Falle eines im Überwachungsbereich (3) festgestellten leuchtenden Gases zumindest enthaltend Metalldampf und/oder eines dritten Alarms/Schaltsignals im Falle, dass das im Überwachungsbereich (3) erfasste Licht einem leuchtenden Gas zumindest enthaltend Metalldampf nicht zuordenbar ist, ausgebildet ist.

11. Verwendung eines Verfahrens nach einem der Ansprüche 1 bis 5 beziehungsweise einer Vorrichtung (1) nach einem der Ansprüche 6 bis 10 zur Überwachung eines in einem Schaltschrank (9) angeordneten Überwachungsbereichs (3).

## Claims

1. Method for distinguishing a light arc from a luminous gas at least containing metal vapor, comprising the steps of
- detecting light in a monitoring region (3),
- measuring a first intensity of the detected light at a first wavelength λ1 ,
- measuring a second intensity of the detected light at a second, larger wavelength A2,
wherein
- the ratio Iλ₁/Iλ₂ between the first intensity Iλ₁ and the second intensity Iλ₂ is determined and
- the detected light is associated with a luminous gas at least containing metal vapor if said ratio I_{λ1}/I_{λ2} is smaller than a predeterminable second threshold value, wherein
- the first wavelength λ1 is selected in a range between 300 nm and 400 nm and the second wavelength λ2 is selected in a range between 650 nm and 750 nm.

2. Method according to claim 1, **characterized in that** the second threshold value is selected in a range of from 0.0125 to 5.

3. Method according to either claim 1 or claim 2, **characterized in that** the value 2.5 is selected for the second threshold value.

4. Method according to any of claims 1 to 3, **characterized in that** a second alarm or a second switching signal is issued if a luminous gas at least containing metal vapor is determined in the monitoring region (3) and/or a third alarm or a third switching signal is issued if the light detected in the monitoring region (3) cannot be associated with a luminous gas at least containing metal vapor.

5. Method according to any of claims 1 to 4, **characterized in that** the monitoring region (3) is arranged within a switch cabinet.

6. Apparatus (1) for distinguishing a light arc from a luminous gas at least containing metal vapor, comprising
- at least one light-sensitive element (2a, 2b) for detecting light in a monitoring region (3),
- a measuring device (4) for measuring a first intensity Iλ₁ of the detected light at a first wavelength λ1 and for measuring a second intensity Iλ₂ of the detected light at a second, larger wavelength λ2,
and
- an evaluation unit (5) for determining the ratio I_{λ1}/I_{λ2} between the first intensity Iλ₁ and the second intensity Iλ₂ and for associating the detected light with a luminous gas at least containing metal vapor if said ratio I_{λ1}/I_{λ2} is smaller than a predeterminable second threshold value, wherein the first wavelength λ1 is in a range between 300 nm and 400 nm and the second wavelength λ2 is in a range between 650 nm and 750 nm.

7. Apparatus (1) according to claim 6, **characterized by** two light-sensitive elements (2a, 2b) and optical filters (6a, 6b) upstream of the light-sensitive elements (2a, 2b), the filter or filters (6a) upstream of the first light-sensitive element (2a) primarily allowing light of the first wavelength λ1 to pass through and the filter or filters (6b) upstream of the second light-sensitive element (2b) primarily allowing light of the second wavelength λ2 to pass through.

8. Apparatus (1) according to claim 7, **characterized in that** the first and/or second optical filter (6a, 6b) is/are designed as a bandpass filter.

9. Apparatus (1) according to claim 8, **characterized in that** a maximum transmission of the first optical filter (6a) is in a wavelength range between 300 nm and 400 nm and a maximum transmission of the second optical filter (6b) is in a wavelength range between 650 nm and 750 nm.

10. Apparatus (1) according to any of claims 6 to 9, **characterized by** an output (8) which is designed to issue a second alarm/switching signal in the event of a luminous gas at least containing metal vapor being determined in the monitoring region (3) and/or a third alarm/switching signal in the event that the light detected in the monitoring region (3) cannot be associated with a luminous gas at least containing metal vapor.

11. Use of a method according to any of claims 1 to 5 or of an apparatus (1) according to any of claims 6 to 10 for monitoring a monitoring region (3) arranged in a switch cabinet (9).

## Revendications

1. Procédé permettant de distinguer un arc électrique d'un gaz lumineux contenant au moins de la vapeur métallique, comprenant les étapes de
- détection de lumière dans une zone de surveillance (3),
- mesure d'une première intensité de la lumière détectée à une première longueur d'onde λ1,
- mesure d'une seconde intensité de la lumière détectée à une seconde longueur d'onde λ2 plus grande,
dans lequel
- le rapport I_{λ1}/I_{λ2} entre la première intensité I_{λ1} et la seconde intensité I_{λ2} est déterminé, et
- la lumière détectée est attribuée à un gaz lumineux contenant au moins de la vapeur métallique si ledit rapport I_{λ1}/I_{λ2} est inférieur à une seconde valeur seuil prédéterminable,
- la première longueur d'onde λ1 étant choisie dans une plage comprise entre 300 et 400 nm et la seconde longueur d'onde λ2 étant choisie dans une plage comprise entre 650 et 750 nm.

2. Procédé selon la revendication 1, **caractérisé en ce que** la seconde valeur seuil est choisie dans une plage de 0,0125 à 5.

3. Procédé selon la revendication 1 ou 2, **caractérisé en ce que** la valeur 2,5 est choisie comme seconde valeur seuil.

4. Procédé selon l'une des revendications 1 à 3, **caractérisé en ce qu'**une deuxième alarme ou un deuxième signal de commutation est émis lorsqu'un gaz lumineux contenant au moins de la vapeur métallique est détecté dans la zone de surveillance (3) et/ou une troisième alarme ou un troisième signal de commutation est émis lorsque la lumière détectée dans la zone de surveillance (3) ne peut pas être attribuée à un gaz lumineux contenant au moins de la vapeur métallique.

5. Procédé selon l'une des revendications 1 à 4, **caractérisé en ce que** la zone de surveillance (3) est disposée à l'intérieur d'une armoire de distribution.

6. Dispositif (1) permettant de distinguer un arc électrique d'un gaz lumineux contenant au moins de la vapeur métallique, comprenant
- au moins un élément photosensible (2a, 2b) permettant de détecter de la lumière dans une zone de surveillance (3),
- un appareil de mesure (4) permettant de mesurer une première intensité I_{λ1} de la lumière détectée à une première longueur d'onde λ1 et de mesurer une seconde intensité I_{λ2} de la lumière détectée à une seconde longueur d'onde λ2 plus grande, et
- une unité d'évaluation (5) permettant de déterminer le rapport I_{λ1}/I_{λ2} entre la première intensité I_{λ1} et la seconde intensité I_{λ2} et d'attribuer la lumière détectée à un gaz lumineux contenant au moins de la vapeur métallique si ledit rapport I_{λ1}/I_{λ2} est inférieur à une seconde valeur seuil prédéterminable, la première longueur d'onde λ1 étant comprise dans une plage entre 300 et 400 nm et la seconde longueur d'onde λ2 étant comprise dans une plage entre 650 et 750 nm.

7. Dispositif (1) selon la revendication 6, **caractérisé par** deux éléments photosensibles (2a, 2b) et des filtres optiques (6a, 6b) disposés en amont des éléments photosensibles (2a, 2b), le ou les filtres (6a) disposés en amont du premier élément photosensible (2a) laissant principalement passer de la lumière à la première longueur d'onde λ1 et le ou les filtres (6b) en amont du second élément photosensible (2b) laissant principalement passer de la lumière à la seconde longueur d'onde λ2.

8. Dispositif (1) selon la revendication 7, **caractérisé en ce que** le premier et/ou le second filtre optique (6a, 6b) sont réalisés sous la forme d'un filtre passe-bande.

9. Dispositif (1) selon la revendication 8, **caractérisé en ce qu'**une transparence maximale du premier filtre optique (6a) se trouve dans une plage de longueurs d'onde comprise entre 300 et 400 nm et une transparence maximale du second filtre optique (6b) se trouve dans une plage de longueurs d'onde comprise entre 650 et 750 nm.

10. Dispositif (1) selon l'une des revendications 6 à 9, **caractérisé par** une sortie (8) conçue pour émettre une deuxième alarme/un deuxième signal de commutation en cas d'identification d'un gaz lumineux contenant au moins de la vapeur métallique dans la zone de surveillance (3) et/ou une troisième alarme/un troisième signal de commutation dans le cas où la lumière détectée dans la zone de surveillance (3) ne peut pas être attribuée à un gaz lumineux contenant au moins de la vapeur métallique.

11. Utilisation d'un procédé selon l'une des revendications 1 à 5 ou d'un dispositif (1) selon l'une des revendications 6 à 10 pour la surveillance d'une zone de surveillance (3) disposée dans une armoire de distribution (9).
